(19) Europäisches Patentamt
European Patent Office
Office européen des brevets

(11) **EP 2 538 414 B1**

(12) **FASCICULE DE BREVET EUROPEEN**

(45) Date de publication et mention
de la délivrance du brevet:
**28.08.2019 Bulletin 2019/35**

(51) Int Cl.:
*G11C 5/00* *(2006.01)*     *G11C 11/412* *(2006.01)*
*H03K 3/037* *(2006.01)*     *H03K 19/003* *(2006.01)*

(21) Numéro de dépôt: **12173220.0**

(22) Date de dépôt: **22.06.2012**

(54) **Dispositif de mémoire corrigeant l'effet de collisions de particules à hautes énergie**

Speichervorrichtung, die den Kollisionseffekt von Hochenergiepartikeln korrigiert

Memory device correcting the effect of high-energy particle collisions

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.06.2011 FR 1101934**

(43) Date de publication de la demande:
**26.12.2012 Bulletin 2012/52**

(73) Titulaire: **Thales**
**92400 Courbevoie (FR)**

(72) Inventeurs:
• **Jacquet, Bruno**
**31270 Villeneuve Tolosane (FR)**
• **Rodriguez, Raoul**
**31150 Bruguières (FR)**
• **Lavalette, Vincent**
**31300 Toulouse (FR)**

(74) Mandataire: **Brunelli, Gérald**
**Marks & Clerk France**
**Immeuble Visium**
**22, avenue Aristide Briand**
**94117 Arcueil Cedex (FR)**

(56) Documents cités:
**EP-A1- 0 951 145     WO-A1-00/54410**
**JP-A- H05 243 916     US-A1- 2009 204 933**
**US-A1- 2009 322 401**

**Description**

La présente invention porte sur un dispositif de mémoire corrigeant l'effet de collisions de particules à hautes énergie, notamment dans le domaine aérospatial.

Dans les systèmes à semi-conducteurs, l'impact d'une particule à haute énergie peut provoquer des effets indésirables.

En particulier, pour des cellules ou points mémoires, l'impact d'une particule à haute énergie peut provoquer son changement d'état, ou de valeur mémorisée. Par exemple un bit mémorisé à une valeur 1 peut passer à une valeur 0, et vice versa.

On appelle durcissement de composants électroniques contre les rayonnements ionisants et les particules hautement énergétiques, un mode de conception, de réalisation et de test des systèmes et composants électroniques pour les rendre résistants aux dysfonctionnements et dégradations causés par des rayonnements électromagnétiques et les particules subatomiques énergétiques rencontrés lors des vols spatiaux ou en haute altitude, ainsi que dans l'environnement des réacteurs nucléaires, voire lors d'opérations militaires.

Un effet singulier peut être provoqué au passage d'une particule unique, généralement un ion lourd ou un proton énergétique, et peut engendrer des effets transitoires (erreurs logicielles ou SEU pour "Single Event Upset" en langue anglaise) et/ou des effets permanents (erreurs matérielles ou SEL pour "Single Event Latchup" en langue anglaise).

Un SEU se matérialise typiquement par le changement d'état logique d'une cellule mémoire sous l'effet d'une particule chargée. C'est un effet transitoire qui sera effacé par la réécriture de la cellule mémoire affectée. Tout circuit électronique qui possède des cellules mémoires est susceptible de connaître des SEU.

Il est connu des systèmes mettant en oeuvre une triple redondance modulaire ou TMR pour "Triple Modular Redundancy" en langue anglaise. De tels systèmes consistent essentiellement à tripler une cellule mémoire ou point mémoire, et à inclure en sortie de ces trois cellules mémoires en redondances, un élément de vote pour fixer en sortie la valeur majoritaire parmi les trois cellules mémoire.

Ainsi, lors de l'impact d'une particule à haute énergie entrainant un SEU et un changement d'état ou de valeur d'une cellule mémoire, en utilisant un élément de vote avec un cadencement d'horloge suffisamment élevé pour que la probabilité de deux SEU simultanés sur au moins deux des trois cellules mémoires en redondance soit quasi-nulle, l'impact est corrigé par un tel système.

La réalisation de tels systèmes est de coût élevé.

En outre, ce type de systèmes est difficilement mis en oeuvre lorsque l'on désire réaliser des fonctions de type RF (pour radiofréquences) en raison de la pollution spectrale générée par l'horloge de cadencement du rafraîchissement des données ou, pour d'autres applications, lorsque la complexité de la triple redondance modulaire ou TMR avec un système de vote n'est pas acceptable.

La demande de brevet US2009/0322401A1 divulgue un circuit tolérant aux effets de collisions de particules et comprenant un verrou. Le circuit peut maintenir des valeurs de données correctes même après l'apparition d'une collision. Le circuit tolérant aux effets de collisions de particules peut introduire un retard dans une boucle de rétroaction, transmettant ainsi la valeur de l'erreur à un élément de la boucle de rétroaction à différents moments, empêchant ainsi la propagation de l'erreur dans le circuit tolérant aux effets de collisions de particules. La demande de brevet US2009/204933A divulgue un système mettant en oeuvre une triple redondance modulaire.

La demande de brevet EP 0 951 145A1 divulgue un circuit pour l'acquisition de signaux analogiques binaires.La demande de brevet JPH05 243 916A divulgue un circuit de bascule muni d'une fonction de prévention d'erreurs d'inversions logiques.

Un but de l'invention est de pallier les problèmes précédemment cités.

Il est proposé, selon un aspect de l'invention, un dispositif de mémoire corrigeant automatiquement l'effet de collisions de particules à hautes énergie selon la revendication 1.

Un tel dispositif de mémoire, permet, à coût réduit, et sans horloge de cadencement du rafraîchissement des données pouvant perturber des fonctions RF, de réaliser un dispositif de mémoire résistant aux collisions de particules à hautes énergie.

Ainsi, un autorafraichissement de la donnée mémorisée ayant subi une collision de particule à haute énergie est possible.

Un tel dispositif est facilement réalisable, tant au moyen d'ASIC qu'au moyen de composants discrets, contrairement à la triple redondance modulaire ou TMR qui est plus coûteuse et encombrante en composants discrets.

Dans un mode de réalisation, ladite cellule mémoire comprend une bascule D.

L'utilisation d'une bascule D ou "D Flip Flop" en langue anglaise, est le type de cellule mémoire le plus couramment utilisé et de coût réduit.

Selon un mode de réalisation, lesdits moyens de rétention comprennent un circuit électronique comprenant une résistance électrique et un condensateur.

Un circuit de type RC pour effectuer la rétention de la valeur mémorisée dans la cellule mémoire est insensible aux collisions de particules à hautes énergie. Un tel circuit est de surcroît aisé à réaliser et de coût réduit.

Par exemple, lesdits moyens de rétention comprennent, en outre, un Trigger de Schmitt.

L'utilisation d'un Trigger de Schmitt permet de transmettre en sortie du système un signal exempt d'ondulations en éliminant les variations de tension internes générées sur le circuit RC dues aux collisions de particules à hautes énergie. Il permet aussi , en fonction des valeurs R et C, de paramétrer correctement le temps de rétention.

Selon un mode de réalisation, lesdits moyens de détection comprennent des moyens de réalisation d'une fonction "ou exclusif".

L'utilisation d'une fonction "ou exclusif" permet, de manière simple, de comparer la valeur de la donnée en sortie de la cellule mémoire et de la valeur dans les moyens de rétention.

Dans un mode de réalisation, lesdits moyens de gestion comprennent deux multiplexeurs.

Une réalisation de moyens de gestion utilisant deux multiplexeurs est une manière simple et de coût réduit de faire la différence entre un changement commandé de la valeur de la mémoire et un changement indésirable de la valeur de la mémoire due à une collision de particule à haute énergie.

Par exemple, une valeur mémorisée est une valeur booléenne, tel un bit de données, dont la valeur est définie comme pouvant valoir 0 ou 1.

Selon un autre aspect de l'invention, il est également proposé un système aérospatial comprenant au moins un dispositif de mémoire selon l'une des revendications précédentes.

Un tel système, par exemple embarqué à bord d'un satellite, est particulièrement robuste aux impacts de particules à haute énergie.

Il est également proposé, selon un autre aspect de l'invention, un procédé de correction automatique de l'effet de collisions de particules à hautes énergie sur un dispositif de mémorisation selon la revendication indépendante 9.

L'invention sera mieux comprise à l'étude de quelques modes de réalisation décrits à titre d'exemples nullement limitatifs et illustrés par les dessins annexés sur lesquels :

- la figure 1 illustre schématiquement un exemple de dispositif de mémoire résistant aux collisions de particules à hautes énergie selon un aspect de l'invention ;
- la figure 2 illustre schématiquement un exemple de réalisation d'un dispositif de la figure 1, selon un aspect de l'invention ;
- les figures 3a, 3b, et 4, illustrent le fonctionnement du dispositif de la figure 2, selon un aspect de l'invention.

Sur l'ensemble des figures, les éléments ayant les mêmes références sont similaires.

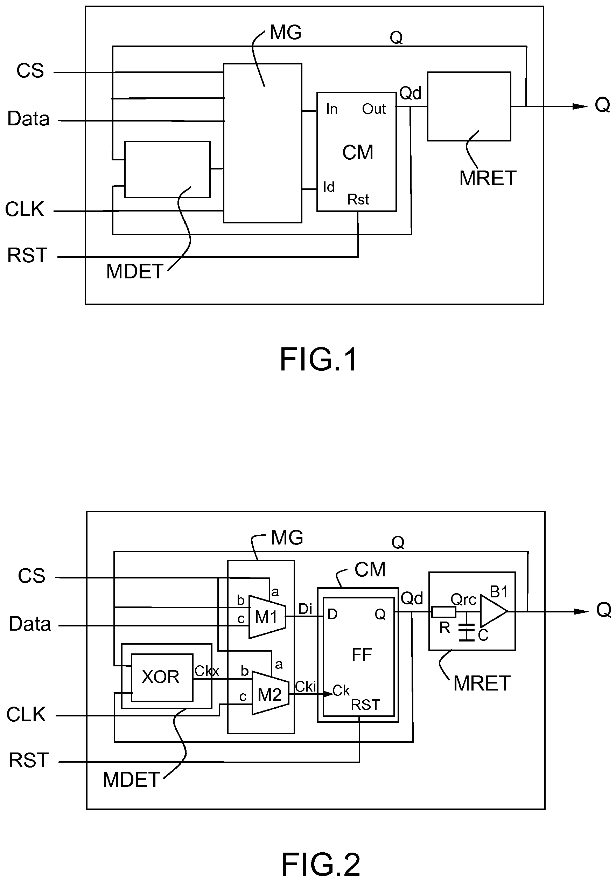

La figure 1 représente un dispositif de mémoire résistant aux collisions de particules à hautes énergie, comprenant au moins une cellule mémoire CM.

Le dispositif comprend également un module de rétention MRET, durant un délai déterminé, de la valeur mémorisée dans la cellule mémoire CM.

Le système comprend, en outre, un module de détection MDET d'un changement d'état de la cellule mémoire CM, par comparaison avec la valeur mémorisée dans le module de rétention MRET, et un module de gestion MG adapté pour déterminer si un changement d'état de la cellule mémoire CM détecté est dû à une particule à haute énergie et, auquel cas, commander un rechargement de la valeur mémorisée dans le module de rétention MRET dans la cellule mémoire CM.

Les signaux intervenant sont les suivants.

Le signal Qd représente la valeur ou l'état mémorisé dans la cellule mémoire ou point mémoire CM. Le signal Qd est transmis au module de rétention MRET ainsi qu'en entrée du module de détection MDET d'un changement d'état de la cellule mémoire CM.

Le signal Q représente la valeur mémorisée en sortie du dispositif de mémoire, durant le délai déterminé, dans le module de rétention MRET. Le signal Q est transmis en sortie du dispositif de mémoire, en entrée du module de détection MDET, ainsi qu'en entrée du module de gestion MG.

Le module de gestion MG reçoit en entrée, la sortie du module de détection MDET, le signal Q représentant la valeur mise en rétention dans le module de rétention MRET durant le délai déterminé. Le module de gestion MG reçoit également en entrée la valeur Data ou état de la donnée à mémoriser dans la cellule mémoire MC, ainsi qu'un signal CS de validation de chargement des données accompagnant le signal Data, pour confirmer un changement d'état normal ou prévu de la valeur à mémoriser dans la cellule mémoire CM.

La cellule mémoire CM reçoit donc, en entrée, la valeur à mémoriser, la sortie du module de gestion MG, un signal de commande du rechargement de la valeur mémorisée dans le module de rétention MRET dans la cellule mémoire CM, lorsque le module de gestion MG a déterminé qu'un changement d'état de la cellule mémoire CM détecté par le module de détection MDET est dû à une particule à haute énergie, et un signal de réinitialisation ou remise à zéro RST.

La figure 2 représente un mode de réalisation d'un dispositif de la figure 1.

La cellule mémoire CM peut être une bascule D FF. Une bascule D est un circuit logique doté d'une ou deux sorties et d'une ou plusieurs entrées. La sortie peut être au niveau logique 0 ou 1. Les changements d'état de la sortie sont déterminés par les signaux appliqués aux entrées et le type d'opérateur. Ce qui différencie les bascules des circuits logiques combinatoires (portes ET, OU, OU Exclusif, etc.), c'est que la sortie maintient son état même après disparition du signal de commande. Comme l'état précédent et la mémorisation interviennent, on parle de logique séquentielle. La bascule est l'élément de base de la logique séquentielle.

En variante, la cellule mémoire peut comprendre un verrou ou "latch" en langue anglaise.

Le module de rétention MRET peut être réalisé sous la forme d'un circuit RC, comprenant une résistance électrique R et un condensateur C. Ainsi, en paramétrant correctement les valeurs de la résistance électrique R et du condensateur C, on peut déterminer précisément le délai de rétention de la valeur en rétention.

De manière optionnelle, le module de rétention MRET peut comprendre, en outre, une bascule de Schmitt B1 aussi appelée trigger de Schmitt ou comparateur à seuils.

Un Trigger de Schmitt est une cellule ayant une entrée V, deux seuils Vil et Vih et une sortie Q. Les seuils Vil et Vih d'un Trigger de Schmitt présentent l'avantage d'être parfaitement caractérisés.

Les seuils Vil et Vih (respectivement seuil bas et seuil haut, ce dernier Vih étant à un potentiel supérieur à Vil) sont maintenus à des potentiels fixes, par exemple grâce à un diviseur de tension composé de trois résistances placées en série entre Vcc et la masse. Les entrées Vih et Vil sont reliées aux points intermédiaires du diviseur. Le fonctionnement est le suivant :

- supposons qu'au départ, V soit à 0 ; Q est alors à 0 ;

- quand V augmente, Q reste à 0 jusqu'à ce que V dépasse Vih ; à ce moment, Q passe à 1 ;

- Q reste à 1 jusqu'au moment où V devient inférieur à Vil ; à ce moment, Q passe à 0 ;

- Q reste à 0 jusqu'à ce que V repasse au-dessus de Vih.

Le module de détection MDET peut comprendre un module XOR de réalisation d'une fonction "ou exclusif" souvent appelée XOR pour acronyme de l'expression anglaise "eXclusive OR" de sortie Ckx.

En variante, le module de détection MDET peut comprendre un module comprenant des comparateurs logiques.

Le module de gestion MG peut comprendre deux multiplexeur M1 et M2, tels que représentés sur la figure 2. Chaque multiplexeur reçoit en entrée un signal de commande a, et deux entrées b et c. La valeur du signal de commande a permet de sélectionner l'entrée b ou c qui est délivrée en sortie Di du multiplexeur M1 ou en sortie Cki du multiplexeur M2.

Pour le multiplexeur M1, ainsi que pour le multiplexeur M2, le signal de commande en entrée est le même, i.e. le signal CS.

Les deux autres entrées du multiplexeur M1 sont les signaux Q et Data, tandis que les deux autres entrées du multiplexeur M2 sont le signal CLK et le signal de sortie Ckx du module de détermination MDET.

En variante, le module de gestion MG peut comprendre tout moyen logique remplissant la même fonction.

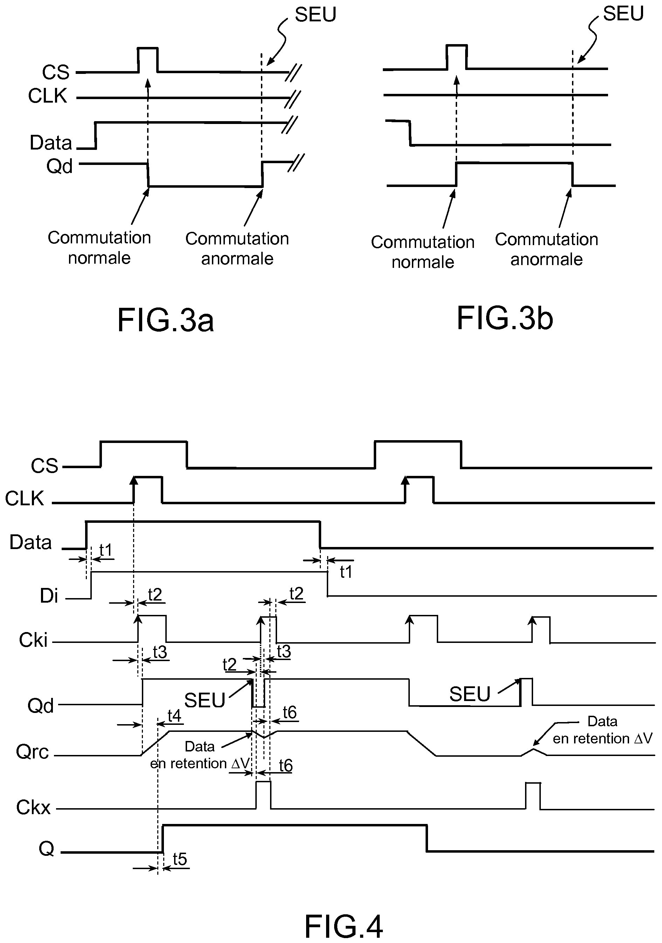

La figure 4 illustre schématiquement, par un diagramme temporel, le fonctionnement du dispositif de la figure 2.

Dans un mode de fonctionnement normal, tant que le signal CS est actif (i.e. de niveau logique égal à 1), les signaux CLK et Data sont sélectionnés et appliqués aux entrées Di et Cki de la bascule FF au travers des deux multiplexeurs M1 et M2.

Le signal Ckx du module XOR est alors "déconnecté" de sorte que toute impulsion transitoire pouvant être générée sur la sortie Ckx du module XOR durant le temps dt de commutation de la bascule FF est bloquée par le multiplexeur M2. Le signal Data est transféré en sortie Q à travers le circuit RC et le tampon de sortie ou bascule de Schmitt B1, sur le front de l'impulsion d'horloge CLK.

Dans un mode de fonctionnement anormal, de rechargement suite à un impact d'une particule à haute énergie ou SEU, tant que le signal CS est inactif (i.e. de niveau logique égal à 0), les signaux Q et Ckx sont sélectionnés et appliqués aux entrées Di et Cki de la bascule D FF au travers des deux multiplexeurs M1 et M2.

Suite à un impact d'une particule à haute énergie SEU, la sortie Qd de la bascule D FF change d'état tandis que la valeur de la donnée initialement chargée est maintenue en rétention dans le circuit RC, i.e. Q n'a pas changé d'état.

Le module XOR génère alors une impulsion Ckx qui recharge sur le front montant, la valeur de la donnée en rétention, dans la bascule FF. Le temps de rétention du circuit RC doit être calculé afin de maintenir, pendant la séquence de rechargement, la variation de tension électrique du signal Qrc dans la gamme Vih ou Vil du circuit (en fonction de la technologie utilisée).

Afin de respecter les contraintes de temps, le système de correction doit répondre à la formule temporelle suivante :

$$t4min + t5min + t1min > t2max + t6max - tholdmax(FF)$$

Sur la figure 4, les instants décrits sont les suivants:

t1 représente le temps de propagation entre l'entrée (signal DATA ou Q) et la sortie (signal Di) du multiplexeur M1 ;
t2 représente le temps de propagation entre une entrée (signal Ckx ou CLK) et la sortie (signal Cki) du multiplexeur M2;
t3 représente le temps de propagation entre l'entrée (signal Cki) et la sortie (signal Qd) de la bascule FF;
t4 représente le temps de montée ou de descente en tension électrique du circuit RC (au sein de la plage Vih ou Vil du trigger de schmitt);
t5 représente le temps de propagation entre l'entrée (signal Qrc) et la sortie (signal Q) du trigger de schmitt B1;
t6 représente le temps de propagation entre une entrée (signal Qd ou Q) et la sortie (signal Ckx) du module XOR; et

tholdmax(FF) représente le temps de maintien max entre l'entrée (signal Di) et le front actif de l'horloge (signal Cki) de la bascule FF.

Il est également à noter qu'avec ce système, le signal de remise à zéro RST doit avoir une durée supérieure au temps de rétention, pour être pris en compte.

## Revendications

1. Dispositif de mémoire corrigeant automatiquement l'effet de collisions de particules à hautes énergie, comprenant une cellule mémoire (CM);

   - des moyens de rétention (MRET), durant un délai déterminé, d'un seul exemplaire d'une valeur mémorisée (Qd) dans ladite cellule mémoire (CM), **caractérisé en ce que** le dispositif de mémoire en outre comprend:

   - des moyens de détection (MDET) d'un changement d'état de ladite cellule mémoire (CM), par comparaison de la valeur mémorisée (Qd) dans ladite cellule mémoire (CM) avec la valeur en rétention dans lesdits moyens de rétention (MRET); et
   - des moyens de gestion (MG) comprenant des moyens de multiplexage adaptés pour déterminer si un changement d'état de ladite cellule mémoire (CM) détecté est dû à une collision de particule à haute énergie ou est un changement d'état commandé, les moyens de multiplexage recevant en entrée une sortie du module de détection (MDET), un signal (Q) représentant la valeur mise en rétention dans le module de rétention (MRET) durant le délai déterminé, un état (Data) de la donnée à mémoriser dans la cellule mémoire (MC), ainsi qu'un signal (CS) de validation de chargement des données accompagnant ledit état (Data) confirmant un changement d'état commandé de la valeur à mémorisée dans ladite cellule mémoire, et adaptés pour, au cas où le changement d'état de ladite cellule mémoire détecté est dû à une collision de particule à haute énergie, commander automatiquement un rechargement de la valeur mémorisée dans lesdits moyens de rétention (MRET) dans ladite cellule mémoire (CM), permettant ainsi d'éviter l'intervention d'une horloge de cadencement du rafraîchissement des données pouvant perturber des fonctions de type radiofréquences RF.

2. Dispositif selon la revendication 1, dans lequel ladite cellule mémoire (CM) comprend une bascule D (FF).

3. Dispositif selon la revendication 1 ou 2, dans lequel lesdits moyens de rétention (MRET) comprenant un circuit électronique (RC) comprenant une résistance électrique (R) et un condensateur (C).

4. Dispositif selon la revendication 3, dans lequel lesdits moyens de rétention (MRET) comprennent, en outre, un Trigger de Schmitt (B1).

5. Dispositif selon l'une des revendications 1 à 4, dans lequel lesdits moyens de détection (MDET) comprennent des moyens (XOR) de réalisation d'une fonction "ou exclusif".

6. Dispositif selon l'une des revendications 1 à 5, dans lequel lesdits moyens de gestion (MG) comprennent deux multiplexeurs (M1, M2).

7. Dispositif selon l'une des revendications précédentes, dans lequel une valeur mémorisée est une valeur booléenne.

8. Système aérospatial **caractérisé en ce qu'**il comprend au moins un dispositif de mémoire selon l'une des revendications précédentes.

9. Procédé de correction automatique de l'effet de collisions de particules à hautes énergie sur un dispositif de mémorisation comprenant les étapes consistant à :

- mémoriser une donnée,
- maintenir en rétention, durant un délai déterminé, un seul exemplaire de la valeur mémorisée, **caractérisé par**
- détecter un changement de valeur de ladite valeur mémorisée, par comparaison de la valeur mémorisée et de la valeur en rétention, et
- déterminer par des moyens de gestions comprenant des moyens de multiplexage si un changement détecté de valeur de ladite valeur mémorisée est dû à une collision de particule à haute énergie ou est un changement commandé, les moyens de multiplexage recevant en entrée une sortie du module de détection (MDET), un signal (Q) représentant la valeur mise en rétention dans le module de rétention (MRET) durant le délai déterminé, un état (Data) de la donnée à mémoriser dans la cellule mémoire (MC), ainsi qu'un signal (CS) de validation de chargement des données accompagnant ledit état (Data) confirmant un changement commandé de la valeur à mémorisée dans la dite cellule mémoire, et, au cas où le changement de valeur de ladite valeur mémorisée est dû à une collision de particule à haute énergie, commander automatiquement un rechargement de ladite valeur par la valeur en rétention, permettant ainsi d'éviter l'intervention d'une horloge de cadencement du rafraîchissement des données pouvant perturber des fonctions de type radiofréquences RF.

**Patentansprüche**

1. Speichergerät zum automatischen Korrigieren des Effekts von Partikelkollisionen mit hoher Energie, das eine Speicherzelle (CM) umfasst;

- Mittel (MRET) zum Zurückhalten, für eine bestimmte Zeit, einer einzigen Kopie eines gespeicherten Werts (Qd) in der Speicherzelle (CM), **dadurch gekennzeichnet, dass** das Speichergerät ferner Folgendes umfasst:
- Mittel (MDET) zum Erkennen einer Änderung des Zustands der Speicherzelle (CM) durch Vergleichen des gespeicherten Werts (Qd) in der Speicherzelle (CM) mit dem in dem Rückhaltemittel (MRET) zurückgehaltenen Wert; und
- Verwaltungsmittel (MG), die Multiplexiermittel umfassen, ausgelegt zum Feststellen, ob eine erkannte Änderung des Zustands der Speicherzelle (CM) auf eine Hochenergie-Partikelkollision zurückzuführen oder eine gesteuerte Zustandsänderung ist, wobei die Multiplexiermittel am Eingang einen Ausgang des Erkennungsmoduls (MDET), ein Signal (Q), das den für die bestimmte Zeit in dem Rückhaltemittel (MRET) zurückgehaltenen Wert repräsentiert, einen Zustand (Data) der in der Speicherzelle (CM) zu speichernden Daten sowie ein Signal (CS) zum Validieren der Ladung der den Zustand (Data) begleitenden Daten empfangen, das eine gesteuerte Änderung des Zustands des zu speichernden Werts in der Speicherzelle bestätigt, und ausgelegt zum automatischen Steuern, falls die erkannte Änderung des Zustands der Speicherzelle auf eine Hochenergie-Partikelkollision zurückzuführen ist, eines erneuten Ladens des gespeicherten Wertes in die Rückhaltemittel (MRET) in der Speicherzelle (CM), so dass die Intervention eines Taktsignals der Auffrischung der Daten, die Funktionen des Radiofrequenztyps RF stören kann, vermieden werden kann.

2. Gerät nach Anspruch 1, bei dem die Speicherzelle (CM) einen Flipflop D (FF) umfasst.

3. Gerät nach Anspruch 1 oder 2, bei dem die eine elektronische Schaltung (RC) umfassenden Rückhaltemittel (MRET) einen elektrischen Widerstand (R) und einen Kondensator (C) umfassen.

4. Gerät nach Anspruch 3, bei dem die Rückhaltemittel (MRET) ferner einen Schmitt-Trigger (B1) umfassen.

5. Gerät nach einem der Ansprüche 1 bis 4, bei dem die Erkennungsmittel (MDET) Mittel (XOR) zum Realisieren einer "Exklusiv-Oder"-Funktion umfassen.

6. Gerät nach einem der Ansprüche 1 bis 5, bei dem die Verwaltungsmittel (MG) zwei Multiplexer (M1, M2) umfassen.

7. Gerät nach einem der vorherigen Ansprüche, bei dem ein gespeicherter Wert ein boolescher Wert ist.

8. Luft- und Raumfahrtsystem, **dadurch gekennzeichnet, dass** es wenigstens ein Speichergerät nach einem der vorherigen Ansprüche umfasst.

9. Verfahren zum automatischen Korrigieren des Effekts von Partikelkollisionen hoher Energie auf einem Speichergerät, das die folgenden Schritte beinhaltet:

   - Speichern eines Datenelements,
   - Zurückhalten, für eine bestimmte Zeit, einer einzigen Kopie des gespeicherten Wertes, **gekennzeichnet durch**
   - Erkennen einer Werteänderung des gespeicherten Wertes durch Vergleichen des gespeicherten Wertes und des zurückgehaltenen Wertes, und
   - Feststellen, durch Verwaltungsmittel, die Multiplexiermittel umfassen, ob eine erkannte Werteänderung des gespeicherten Wertes auf eine Hochenergie-Partikelkollision zurückzuführen oder eine gesteuerte Änderung ist, wobei die Multiplexiermittel am Eingang einen Ausgang des Erkennungsmoduls (MDET), ein Signal (Q), das den für eine bestimmte Zeit im Rückhaltemittel (MRET) zurückgehaltenen Wert repräsentiert, einen Zustand (Data) des in der Speicherzelle (CM) zu speichernden Datenelements sowie ein Signal (CS) zum Validieren der Ladung der den Zustand (Data) begleitenden Daten empfangen, das eine gesteuerte Änderung des in der Speicherzelle zu speichernden Wertes bestätigt und, falls die Werteänderung des gespeicherten Wertes auf eine Hochenergie-Partikelkollision zurückzuführen ist, automatisches Steuern eines erneuten Ladens des Wertes mit dem zurückgehaltenen Wert, so dass eine Intervention eines Taktsignals der Auffrischung der Daten verhindert werden kann, die Funktionen des Radiofrequenztyps RF stören kann.

## Claims

1. A memory device automatically correcting the effect of collisions of high-energy particles, comprising a memory cell (CM):
   retention means (MRET) for retaining, for a determined period, a single copy of a stored value stored (Qd) in said memory cell (CM), **characterised in that** the memory device further comprises:

   detection means (MDET) for detecting a change of state of said memory cell (CM), by comparing the stored value (Qd) stored in said memory cell (CM) with the value in retention in said retention means (MRET); and management means (MG) comprising complexing means suitable for determining whether a detected change of state of said memory cell (CM) is due to a high-energy particle collision or is a commanded state change, the multiplexing means receiving as input an output of the detection means (MDET), a signal (Q) representing the value put in retention in the retention module (MRET) for the predetermined period, a state (Data) of the data item to be stored in the memory cell (MC), as well as a signal (CS) for validation of data loading accompanying said state (Data) confirming a change of commanded state of the value to be memorized in said memory cell, and adapted to, in case the detected state change of said memory cell is due to a high-energy particle collision, automatically control a reloading of the value stored in said retention means (MRET) in said memory cell (CM), thus making it possible to avoid the intervention of a data refresh timing clock which can disturb functions of the RF radio-frequency type.

2. Device according to claim 1, wherein said memory cell (CM) comprises a flipflop D (FF).

3. Device according to claim 1 or 2, wherein said retention means (MRET) comprising an electronic circuit (RC) comprise an electrical resistance (R) and a capacitor (C).

4. Device according to claim 3, wherein said retention means (MRET) further comprise a Schmitt Trigger (B1).

5. Device according to one of claims 1 to 4, wherein said detection means (MDET) comprise means (XOR) for performing a function "or exclusive".

6. Device according to one of claims 1 to 5, wherein said management means (MG) comprise two multiplexers (M1, M2).

7. Device according to one of the preceding claims, wherein a memorized value is a Boolean value.

8. Aerospace system **characterized in that** it comprises at least one memory device according to one of the preceding claims.

9. A method of automatically correcting the effect of high-energy particle collisions on a storage device comprising the steps of:

- memorizing a data item,
- maintaining in retention, during a predetermined period, a single copy of the memorized value, **characterized by**
- detecting a change in value of said memorized value, by comparing the memorized value and the value in retention, and
- determining, using management means comprising multiplexing means, if a detected change in value of said stored value is due to a high-energy particle collision or is a commanded change, the multiplexing means receiving as input an output of the detection module (MDET), a signal (Q) representing the value set in retention in the retention module (MRET) during the predetermined period, a state (Data) of the data item to be stored in the memory cell (MC), as well as a data loading validation signal (CS) accompanying said state (Data) confirming a commanded change of the value to be memorized in said memory cell, and, in the case where the value change of said memorized value is due to a high-energy particle collision, automatically controlling a reloading of said value by the retention value, thereby avoiding the intervention of a data refresh timing clock which can disturb functions of the RF radio-frequency type.

FIG.1

FIG.2

EP 2 538 414 B1

FIG.3a

FIG.3b

FIG.4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090322401 A1
- US 2009204933 A
- EP 0951145 A1
- JP H05243916 A